# EUROPEAN PATENT APPLICATION

(11) **EP 2 950 112 A2**
(43) Date of publication of application: **02.12.2015**
(21) Application number: 15169394.2
(22) Date of filing: 27.05.2015
(51) Int. Cl.: G01R 31/01

(54) **DIAGNOSING A DC TO DC CONVERTER OUTPUT CAPACITOR AGING**

(30) Priority: 28.05.2014 FI 20145486
(71) Applicant: Powernet Oy, 44150 Äänekoski (FI)
(72) Inventor: Hannonen, Janne, 53850 Lappeenranta (FI); Honkanen, Jari, 53850 Lappeenranta (FI)
(74) Representative: Papula Oy

(57) **Abstract**

A method for real-time diagnosing the condition of an output capacitor (18) of the output stage (6) of a switching mode DC to DC converter block (3) comprises the steps of providing a reference step response of the output voltage in response to a step change of the requested output voltage; making a step change the requested output voltage; providing measurements of the actual step response of the output voltage; comparing the actual step response with the reference step response of the output voltage; and determining the condition of the output capacitor on the basis of said comparison.

## Description

### FIELD OF THE INVENTION

The present invention relates generally to power supplies, in particular to DC to DC converters and the aging of the electric components thereof. The present invention is focused on monitoring and detecting the aging of the output capacitors of switching mode DC to DC converters.

### BACKGROUND OF THE INVENTION

Due to their many advantageous features, switching mode power supplies (SMPS) such as switching mode DC to DC converters are widely used in various power conversion applications e.g. in industry, transportation, and avionics. In general, switching mode power supplies provide e.g. good temperature stability, low ripple voltage, and high overall efficiency.

A key component in a typical switching mode DC to DC converter is the output capacitor used in the output circuit of the converter to filter the output voltage. Due to high energy density versus component size, electrolytic capacitors form the most common type of capacitors used for this purpose.

On the other hand, as well known, electrolytic capacitors suffer from degradation and failures, mainly due to vaporization and degradation of the electrolyte liquid thereof. The degradation of an electrolytic capacitor, as a decrease in the capacitance and an increase in the internal equivalent series resistance (ESR), results in disturbances in the operation of the entire power supply. Therefore, it is to be ensured that the capacitors, or the entire device, are exchanged before the operation of the power supply is disturbed too much. There are standards defining limits for proper operation of an electrolytic capacitor. For example, an electrolytic capacitor may be determined inoperative, when its capacitance has decreased by 20%, or when its equivalent series resistance has increased multifold. However, the problem is that the direct diagnosing of the performance of a capacitor integrated in an output circuit of a power supply is difficult and burdensome.

One common solution is to use fixed, calendar-based maintenance periods for changing the capacitors or the entire power supplies. Naturally, this is not optimal, taking into account the statistical variation between the aging characteristics of the individual capacitor components.

Also some on-line methods for evaluating the condition of and predicting the failure of the output capacitors has been reported, which methods are based on real-time measurements of some parameters from the circuit, a part of which the capacitor forms. The measured values may be used in complex algorithms modeling the performance and aging of the capacitor. In many of these approaches, the primary focus is on the internal equivalent series resistance (ESR) of the output capacitor.

Naturally, arranging real-time measurements from operating devices may be burdensome. With regard to the approaches based on determining the ESR, there is a problem in that the total internal equivalent series resistance of a plurality of capacitors connected in parallel is equal to the single resistance value divided by the number of individual capacitor components. Therefore, the absolute change of the total equivalent resistance value to be measured is negligible even though the relative change would exceed the predetermined failure limit. On the other hand, accelerated aging tests have shown that thermal and electrical overstress more likely decreases the capacitance than increases the equivalent series resistance of the output capacitor. Thus, focusing on the resistance changes may lead to false conclusions on the output capacitor condition.

### PURPOSE OF THE INVENTION

It is a purpose of the present invention to provide a novel solution for enabling real-time diagnostics of the condition of the output capacitor of a switching mode DC to DC converter.

### SUMMARY OF THE INVENTION

The method, control unit, and computer program of the present invention are characterized by what is specified in claims 1, 5, and 7, respectively.

According to a first aspect, the present invention is focused on a method for real-time diagnosing the condition of an output capacitor of the output stage of a switching mode DC to DC converter block comprising an input stage, and an output stage; the output voltage out of the output stage being controlled by controlling the input stage according to a requested output voltage.

By real-time diagnosing is meant that the condition of the output capacitor can be performed during the operation of the DC to DC converter.

Various switching mode DC to DC converters are well known in the art, so no detailed description of them is provided here. The present invention is related to converters comprising an input stage for input DC power, and an output stage providing the actual output voltage over an external load. In the output stage, there is an output capacitor for storing the energy and filtering the output voltage. The output capacitor can comprise one single electrolytic capacitor, but it may also be formed by several capacitor elements coupled in parallel.

The DC to DC converter of the present invention can be based on a basic configuration in which the input (primary) and the output (secondary) stages are isolated from each other by means of a transformer. On the other hand, converter can also be based on a non-isolated configuration, in which there are no separate primary and secondary stages.

By converter "block" is meant here a converter unit that the be a complete, stand-alone, operable DC to DC converter device, or just a DC to DC block integrated in a larger power supply, e.g. an AC to DC power supply.

Generally speaking, the operation of a switching mode DC to DC converter is based on switching operation of the DC current of the input stage, whereby the output DC voltage is determined by the pulsing details, e.g. the pulse width ratio, of the switching. Knowing the dependency of the output voltage on the switching details, the switching is adjusted according to the requested output voltage, i.e. the voltage to be provided at the output of the converter, in practice at the output of the output stage. This way, the output voltage out of the output stage is controlled by controlling the input stage.

The requested output voltage can be based e.g. on the desired output voltage selected by the user of the power supply, or on the desired output voltage of the power supply fixedly determined already at the design phase of the converter block. The requested output voltage thus means the output voltage which the DC to DC converter should produce. It could also be called an output voltage reference, according to which the control of the input stage shall be adjusted to make the output voltage out of the output stage in accordance with this reference. Information on the requested output voltage can be defined, and supplied to the control system of the converter block, also by an external device connected to the converter.

In practice, in converters according to the latest design, said controlling can be performed e.g. by means of a digital control unit integrated into the power supply, the control unit comprising a microprocessor coupled to a suitable control circuit. For adjusting the control of the input/primary stage, there is usually a monitoring system for measuring the realized output voltage, and providing a feedback connection for supplying the information on the realized output to the control unit.

According to the present invention, the method comprises the steps of providing a reference step response of the output voltage in response to a step change of the requested output voltage; making a step change in the requested output voltage; providing measurements of the actual step response of the output voltage; comparing the actual step response with the reference step response of the output voltage; and determining the condition of the output capacitor on the basis of said comparison.

By step response is meant here the dynamic behavior of the output voltage in response to a single, sudden, abrupt change, i.e. a step change, of the requested output voltage level. Such step change of the requested output voltage means, naturally, that also the controlling of the input stage by means of the switching is changed abruptly by a corresponding single step change.

In addition to the "static" control of the output, i.e. the selection of an appropriate switching procedure according to the required output voltage, there is often also a dynamic feedback control based on the real-time monitoring of the realized, i.e. the actual, output voltage. Such feedback control can be e.g. used to fine-adjust the control of the input stage so as to keep the output voltage within predetermined tolerances around the required output voltage. The dynamic feedback control can also be used to affect the dynamic behavior of the output voltage in a situation where the required output voltage is changed. Therefore, it is to be ensured that the possible dynamic feedback control does not affect the output voltage dynamics during the diagnosing of the output capacitor condition. This can be made simply by disabling the dynamic feedback control so that only one single step change is generated in the input stage control. Alternatively, the response time of the dynamic feedback control can be made clearly slower than the nominal rate of change of the output voltage in response to a simple step change of the input stage control. The step response characteristics of the output voltage are then primarily determined by the output capacitor. Therefore, if the properties of the output capacitor are changed, also the dynamic behavior of the output voltage is changed. In the present invention, this dependence is utilized for diagnosing the condition of the output capacitor.

The step change can be implemented as a rectangular shaped pulse temporarily increasing or decreasing the requested output voltage. On the other hand, the requested output voltage can be first lowered or increased by an amount of the intended step change, after which the step change is realized by a step increase or decrease, respectively, of the requested output voltage to its initial value.

The reference step response means here a reference dynamic behavior of the output, with which reference dynamic behavior the actual, i.e. the present, dynamic behavior is compared. The reference step response may be, for example, a step response of the output as measured from the converter block after completing its manufacture, i.e. without any aging of the components thereof. It may also be some theoretical step response behavior determined computationally for the converter block type at issue. It may also be based on an average step response based on measurements of a number of similar converter blocks.

Providing a reference step response of the output voltage in response to a step change of the requested output voltage may simply mean having such step response data stored and available for further use. It can be stored in a memory incorporated in a control unit of the power supply of the DC to DC converter block.

Providing measurements of the actual step response of the output voltage may simply comprise receiving the output voltage behavior automatically measured by a monitoring system mentioned above, and at least temporarily storing the received actual step response in the form of measurement data for the step of comparing it with the reference step response. "Providing" may here also comprise the actual step of measuring, via controlling an output monitoring system, the output voltage and the step response thereof. Controlling of the monitoring system, and receiving and storing of the measurements can be carried out by a control unit of the power supply, or of the DC to DC converter block.

In the step of comparing the actual step response with the reference step response of the output voltage, predetermined comparison routines can be used. For example, in one embodiment, the voltage levels of the actual step response and the reference step response at a same predetermined measurement time tₘₑₐₛ after the initiation of the same step change of the requested output voltage are compared.

The measurement time, also called measurement point, can be selected, in principle, wherever on the rising edge of the output voltage step response. However, it should be noted that the step response rising edge is not perfectly linear, especially close to the time of initiation of the step change of the requested output voltage, or at the end of the rising edge. Nonlinearity and inconsistency effects are introduced, if the measurement point is set close to the end or beginning of the step response.

To facilitate the evaluation of the step response measurements, also the magnitude of the step change of the requested output voltage should is preferably selected carefully. The step height needs to be large enough to overcome the effect of measurement noise and hence to obtain repeatable measurement results. On the other hand, too large deviations in the output voltage should be avoided. In many applications, the step height can be e.g. 1 to 5 %, e.g. about 2.5 % of the initial requested output voltage level.

Finally, on the basis of the comparison, the condition of the output capacitor is determined. Determination of the output capacitor condition can be based on various criteria. First, when the actual step response of the output voltage lies within predetermined tolerances from the reference step response, the condition of the output capacitor may be determined to be acceptable. On the other hand, when the actual step response of the output voltage deviates from the reference step response of the output voltage by a predetermined degree, a failure of the output capacitor may be determined.

There may be various criteria for such predetermined degree of deviation. For example, because aging of the electrolytic output capacitor typically results in a decrease of the capacitance thereof and thus acceleration of the dynamic behavior of the output stage, the limit for failure can be set to a specific increase or decrease of the output voltage at the measurement time tₘₑₐₛ.

Also the above steps of comparing the actual step response with the reference step response and determining the condition of the output capacitor may be performed by means of an existing control unit of the power supply of the converter block.

The steps of the method may be repeated at predetermined intervals, e.g. once a day or once a week, until a failure of the output capacitor is determined. By selecting the interval sufficiently short, one can ensure that a failure or harmful change of the output capacitor is detected in time. The interval can also be set to shorten along the increase of the total operating time of the converter block, and thus along the increase of the probability of failure of the output capacitor.

The present invention provides great advantages for operation and maintenance of power supplies comprising a switching mode DC to DC converter block. The present invention provides a reliable solution for real-time diagnosing of the output capacitor aging. When the invention is based on monitoring the output voltage dynamic behavior directly dependent on the capacitance value of the output capacitor, the problems associated with the prior art diagnosing methods focused on the internal equivalent series resistance can be avoided. As one particular advantage, the present invention can be implemented in existing power supply designs without need for any additional hardware or measurement systems.

All what is stated about the advantages, details, and preferred features in the context of the method aspect of the present invention above are applicable, *mutatis mutandis,* also to the control unit and computer program according to the present invention. The same applies vice versa.

According to a second aspect, the present invention is focused on a control unit for real-time diagnosing the condition of an output capacitor of the output stage of a switching mode DC to DC converter block comprising an input stage, and an output stage; the output voltage out of the output stage being controlled by controlling the input stage according to a requested output voltage; the control unit comprising at least one digital processor, and at least one memory coupled to the digital processor.

The term "processor" is to be understood broadly here, covering all kinds of processing units capable of performing the method steps specified below.

The principles of the switching mode DC to DC converters are described above in the context of the method aspect of the present invention, so they are not repeated here. Again, a DC to DC converter block can refer to a complete, stand-alone converter device or to a converter block as a part of a larger power supply apparatus.

According to the present invention, the memory comprises program code which, when executed by the processor, causes the control unit to perform the method according to any of the embodiments described above. The control unit can be a control unit of a known type used in switching mode DC to DC converters. Such typically microcontroller-based digital control units are nowadays commonly integrated in the power supplies for managing the continuous control operations of the different stages of the power supply. However, the control unit differs from the known control units by the specific program code stored in the memory, designed to cause the processor to perform the advantageous method steps of the present invention. Naturally, the control unit and the processor thereof can also be implemented as parts of a complete personal computer (PC), or they can form another type stand-alone control unit.

The principles of the present invention may also be implemented in the form of a power supply comprising a switching mode DC to DC converter block comprising an input stage, and an output stage with an output capacitor; the output voltage out of the output stage being controlled by controlling the input stage according to a requested output voltage. According to the present invention, the power supply further comprises a control unit as defined above.

According to a third aspect, the present invention is focused on a computer program, embodied on a computer-readable medium, comprising program code which, when executed by a processor, causes the processor to perform the method according to any of the embodiments described above. Also here, the terms "computer" and "processor" shall be understood broadly, without limiting the meanings of those terms to any specific types of devices. For example, the "computer program" may be implemented as an embedded software for a microcontroller.

### BRIEF DESCRIPTION OF THE DRAWINGS

In the following, the present invention is described with reference to the accompanying drawings illustrating exemplary embodiments of the present invention, wherein
Figure 1 shows an AC to DC power supply,
Figure 2 illustrates the main circuit of a DC to DC converter block,
Figures 3 and 4 show graphs of the output voltage of a DC to DC converter of Figure 2, controlled according to the present invention, and
Figure 5 shows the steps of a method according to the present invention as a flow chart.

### DETAILED DESCRIPTION OF THE EMBODIMENTS

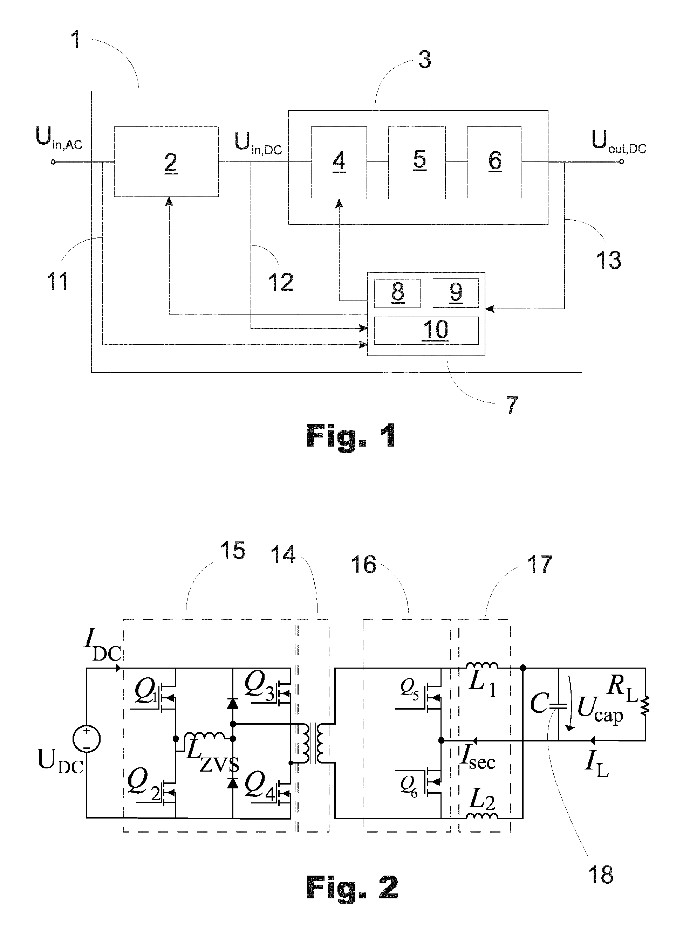

The digitally controlled switching mode AC to DC power supply (1) of Figure 1 converts an input AC voltage

U_{in,AC} into an output DC voltage U_{out,DC} of a desired magnitude. The main building blocks of the power supply comprise an AC to DC converter block (2) converting the input AC voltage initially into a DC voltage U_{in,DC}. This DC voltage is supplied to a DC to DC converter block (3) converting the initial DC voltage at the desired output DC voltage.

The DC to DC converter block of Figure 1 comprises an input stage (4), a step down transformer (5), and an output stage (6). The circuits of the DC to DC converter block can be e.g. as those shown in Figure 2. It is to be noted that instead of this basic configuration, the present invention is also applicable to non-isolated converters without a transformer providing a galvanic isolation between the input and output stages.

The entire power supply is controlled by a digital control unit (7) comprising a microprocessor (8), coupled to a memory (9) and a control circuit (10). The memory can also be integrated within the microprocessor. In particular, the output voltage U_{out,DC} is adjusted by controlling the input stage according to the requested output voltage level.

The power supply comprises monitoring systems (11, 12, 13) for measuring and delivering the input AC voltage U_{in,AC}, the initial DC voltage U_{in,DC}, and the DC output voltage U_{out,DC} to the control unit.

Figure 2 shows a main circuit of a DC to DC converter block. The step down transformer (14) of the converter block is driven with a phase shifted H-bridge (15) in the input stage, operated with a duty cycle adjusted by the digital control unit (not shown in Figure 2) of the converter block. The output stage comprises a synchronous rectifier (16), which also is controlled with the digital control unit, and a current doubler circuit (17), the latter comprising an output capacitor (18) determining the dynamic behavior of the output voltage U_{cap} out of the output stage. The phase shifted converter OF Figure 2 is based on zero voltage switching (ZVS).

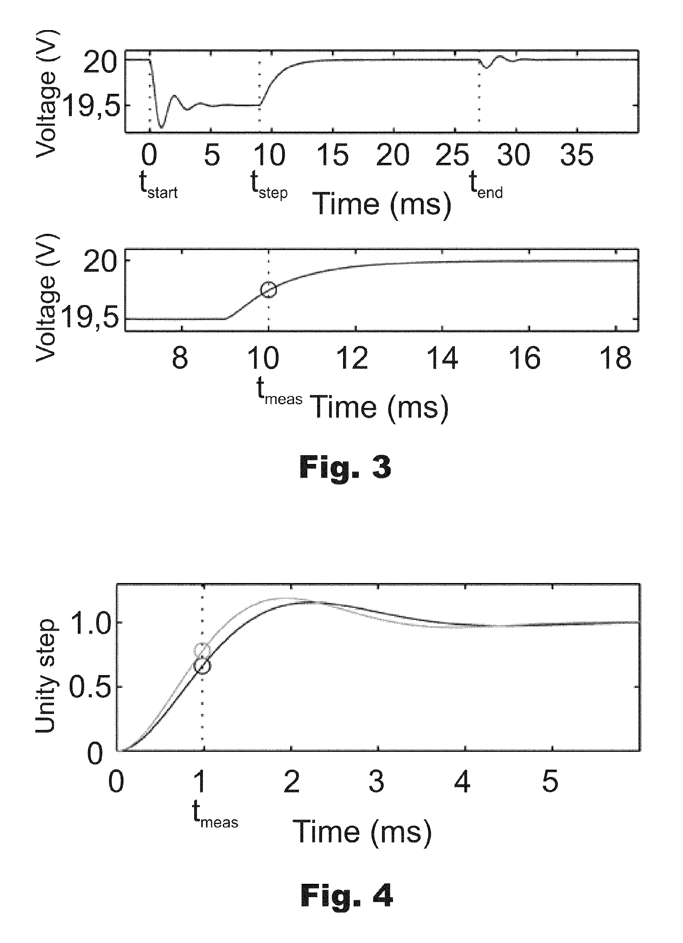

Figure 3 illustrates two graphs of the output voltage during an example procedure for diagnosing the condition of the output capacitor (18) of a DC to DC converter block according to Figure 2. The procedure may be performed online, i.e. during the normal operation of the power supply, a part of which the DC to DC converter block forms. The diagnosing procedure is applied during the converter block operating in a steady state.

The example procedure goes as follows. First, the present duty cycle used to drive the H-bridge is saved before initiating the actual diagnosing procedure. The procedure starts by first decreasing the requested output voltage, at time t = tₛₜₐᵣₜ, from the initial value of 20 V by a step decrease of 0.5 V.

After a settling period tₛₜₐᵣₜ < t < tₛₜₑₚ, a step excitation in the form of a step change of 0.5 V of the requested output voltage is produced by applying a pulse duty cycle corresponding to the normal operation with the initial output voltage of 20 V. The dynamic feedback control of the H-bridge is disabled at this stage, before the step excitation begins, so that the step response of the output voltage is dependent on the circuit physical conditions only. The effect of the dynamic feedback control is shown in the upper graph of figure 3, wherein the initial setting time of the output voltage from 20 V to 19.5, with the dynamic feedback control in use, is radically shorter than the setting time of the actual step response behavior from 19.5 V to 20 V. The step response value of the output voltage is evaluated at a measurement point t = tₘₑₐₛ. The step response is left to settle for up to t = t_{end}, when the H-bridge control is activated again, and the converter continues its normal operation.

The step response of the output voltage is compared with a reference step response determined for similar step excitation. If the output capacitor of the DC to DC converter block output stage has been aged, its capacitance value is decreased from the initial value, and the dynamic operation of the converter block is accelerated in comparison to the reference step response. This kind of situation is illustrated in Figure 4 showing simulated step responses of the output voltage with a fresh output capacitor (the curve with a lower value of the output at the measurement point t = tₘₑₐₛ) and with a degraded output capacitor. In a real device, such increase in the output voltage value at the measurement point can be used as an indication of the output capacitor aging and/or failure.

It is to be noted that in the case of a load with significant capacitance and/or inductance, also the effect of the load on the actual step response of the output voltage is preferably taken into account and compensated in order to truly investigate only the effect of the output capacitor aging on the output voltage dynamics. In some cases, it may be possible to disconnect the load from the DC to DC converter for measuring the step response. Correspondingly, the reference step response can be determined without any load.

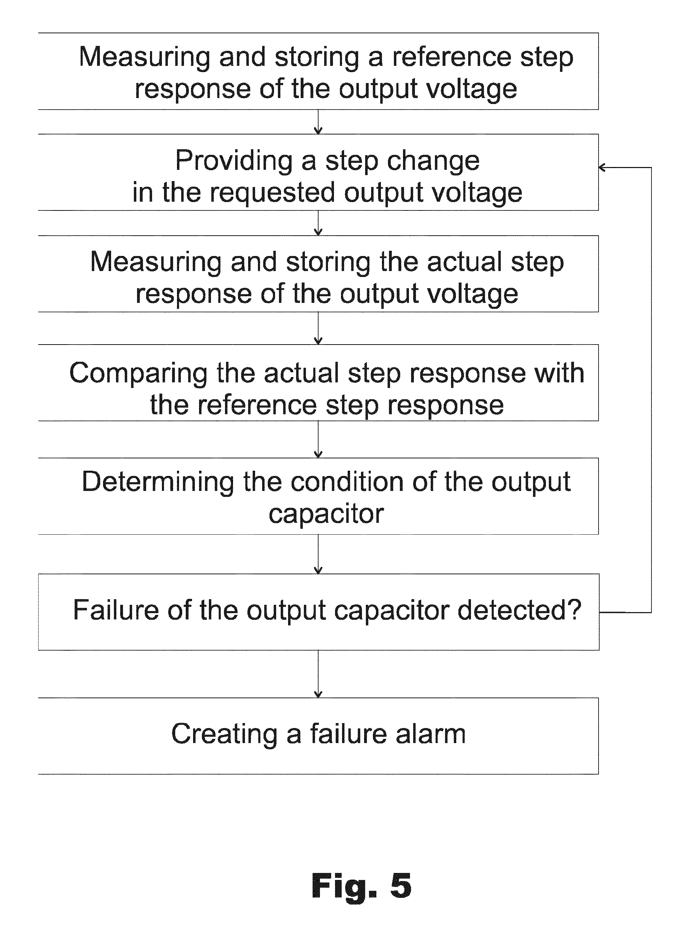

The flow chart of Figure 5 summarizes the steps of a method for diagnosing the condition of an output capacitor of a switching mode DC to DC converter block. First, a reference step response of the output voltage out of the output stage is measured and at least some characteristic parameter thereof is stored in the control unit of the converter block. This can be done already in the manufacturing stage of the converter, or after the previous change of the output capacitor(s). Then, during operation of the converter block, the requested output voltage, on the basis of which the input stage of the converter block is controlled, is changed by a step change similar to that used in measuring the reference step response of the output voltage. The actual step response of the output voltage is then measured, and relevant information of the actual step response is stored in the memory of the control unit.

The actual diagnosis starts by comparing the actual step response with the reference step response. The condition of the output capacitor is then determined on the basis of said comparison, using some predetermined criteria. For example, there can be a predetermined limit for an acceptable difference in the output voltage rise at a particular measurement time after the initiation of the step change of the requested output voltage. A Difference exceeding this limit can result in determining a failure of the output capacitor. If no failure is detected, the procedure starting from providing the step response of the requested output voltage is repeated after a predetermined period.

Detection of a failure of the output capacitor may result in generating a failure alarm by the control unit. Such failure alarm can generate a simple visual or audio alarm detectable from the outside of the converter block and the power supply in which the converter block is integrated. It is also possible that the control unit is equipped with a transmitting system transmitting such failure alarm as a maintenance request to the operator of the power supply.

It is also possible that some alarms of aging of the output capacitor are generated and possibly transmitted further already before detecting an actual failure.

## Claims

1. A method for real-time diagnosing the condition of an output capacitor (18) of the output stage (6) of a switching mode DC to DC converter block (3) comprising an input stage (4), and an output stage (6); the output voltage out of the output stage being controlled by controlling the input stage according to a requested output voltage;
**characterized in that** the method comprises the steps of:
- providing a reference step response of the output voltage in response to a step change of the requested output voltage;
- making a step change in the requested output voltage;
- providing measurements of the actual step response of the output voltage;
- comparing the actual step response with the reference step response of the output voltage; and
- determining the condition of the output capacitor on the basis of said comparison.

2. A method as defined in any of claim 1, wherein a failure of the output capacitor (18) is determined when the actual step response of the output voltage deviates from the reference step response of the output voltage by a predetermined degree.

3. A method as defined in claim 1 or 2, wherein the step of comparing the actual step response with the reference step response comprises comparing the voltage levels of the actual step response and the reference step response at a same predetermined measurement time after the initiation of the same step change of the requested output voltage.

4. A method as defined in any of claims 1 to 3, wherein the steps of the method are repeated at predetermined intervals until a failure of the output capacitor is determined.

5. A control unit (7) for real-time diagnosing the condition of an output capacitor (18) of the output stage (6) of a switching mode DC to DC converter block (3) comprising an input stage (4), and an output stage (6); the output voltage out of the output stage being controlled by controlling the input stage according to a requested output voltage; the control unit comprising at least one digital processor (8), and at least one memory (9) coupled to the digital processor; **characterized in that** the memory comprises program code which, when executed by the processor (8), causes the control unit (7) to perform the method of any of claims 1 to 4.

6. A power supply (1) comprising a switching mode DC to DC converter block (3) comprising an input stage (4), and an output stage (6) with an output capacitor (18); the output voltage out of the output stage being controlled by controlling the input stage according to a requested output voltage;
**characterized in that** the power supply (1) further comprises a control unit (7) as defined in claim 5.

7. A computer program comprising program code which, when executed by a processor (8), causes the processor to perform the method of any of claims 1 to 4.
